# EUROPEAN PATENT APPLICATION

(11) **EP 4 539 619 A1**
(43) Date of publication of application: **16.04.2025**
(21) Application number: 23818846.0
(22) Date of filing: 27.04.2023
(51) Int. Cl.: H05K 5/00

(54) **DECORATIVE PLATE AND MANUFACTURING METHOD THEREFOR, AND ELECTRONIC DEVICE**

(30) Priority: 08.06.2022 CN 202210643623
(71) Applicant: BYD Company Limited, Shenzhen, Guangdong 518118 (CN)
(72) Inventor: LUO, Fuhua, Shenzhen, Guangdong 518118 (CN); YANG, Jingjie, Shenzhen, Guangdong 518118 (CN); MA, Lan, Shenzhen, Guangdong 518118 (CN)
(74) Representative: Taor, Simon Edward William
(86) International application number: PCT/CN2023/091124
(87) International publication number: WO 2023/236681

(57) **Abstract**

Provided are a decorative plate and a manufacturing method therefor, and an electronic device. The decorative plate comprises a substrate and a decorative layer provided on the surface of the substrate. The surface of the side of the decorative layer distant from the substrate is provided with at least one unit block; in a first direction, the unit block is provided with a plurality of texture units which are continuously arranged; each texture unit is provided with a plurality of texture line grooves, and an extension direction of the plurality of texture line grooves is the same; an included angle between the extension direction of the texture line grooves and the first direction is an extension angle; in the first direction, the extension angles of the texture line grooves in different texture units gradually change.

## Description

### CROSS-REFERENCE TO RELATED APPLICATIONS

The present disclosure claims priority to Chinese Patent Application No. 202210643623.5 and a title of "Decorative plate and manufacturing method and application thereof" filed on June 8, 2022, which is incorporated herein by reference in its entirety.

### FIELD

The present disclosure relates to the field of decorative technology, and in particular to decorative plate and manufacturing method therefor, and electronic device.

### BACKGROUND

With the rapid development of electronic devices, people have increasingly higher requirements for the visual effects of the appearance of electronic devices. However, the current appearance of electronic devices is relatively monotonous in decoration and texture, lacking sufficient expressive power, which cannot meet consumer demands. Therefore, there is a need to provide a novel decorative plate with an appealing appearance to enrich the look of electronic devices and enhance product competitiveness.

### SUMMARY

To solve the above problems, the present disclosure provides a decorative plate that can produce a flowing light and shadow effect as the viewing angle changes, presenting a strong three-dimensional sense. Applying this decorative plate to electronic devices helps enrich the appearance of electronic devices and improve their recognition.

The first aspect of the present disclosure provides the decorative plate includes a substrate and a decorative layer disposed on the surface of the substrate, wherein the surface of the decorative layer away from the substrate has at least one unit block, the unit block is provided with multiple continuously arranged texture units in a first direction, the texture units have multiple texture grooves, and the extension directions of the multiple texture grooves being the same; the extension direction of the texture grooves forms an extension angle with the first direction, and in the first direction, the extension angles of the texture grooves in different texture units gradually change.

In the decorative plate of the present disclosure, the texture grooves in adjacent texture units have different extension directions. Light undergoes reflection, scattering, refraction in different texture units, and then it reflects light of different intensities, presents changes in brightness and scatters out different colors to create a gradient color effect. The gradual change in the extension angle of the texture grooves in different texture units in the first direction enables the block to have a smooth visual change effect. As the viewing angle changes, the light and shadow can flow along the first direction, presenting a dynamic visual effect that greatly enhances the aesthetic appeal of the decorative plate.

In some embodiments, the size of the texture units in the first direction is 0.1mm to 0.5mm.

In some embodiments, the first direction is linear direction, the unit block is circular, the first direction is the radial direction of the circle, and the variation in the extension angle of the texture grooves in multiple texture units within every 1mm distance along the first direction is 10° to 40°.

In some embodiments, the first direction is a straight line direction, the unit block is rectangular, and the variation of the extension angle of the texture grooves in multiple texture units within every 1mm distance in the first direction is 15° to 80°.

In some embodiments, the first direction is a curved direction, the unit block is S-shaped, and the variation in the extension angle of the texture grooves in multiple texture units within every 1mm distance along the first direction is 6° to 35°.

In some embodiments, the variation of the extension angle of the texture grooves in adjacent texture units is 0.5° to 10°.

In some embodiments, in the texture unit, the distance between adjacent texture grooves is 5µm to 120µm.

In some embodiments, the width of the cross-section of the texture groove perpendicular to the extension direction gradually increases in the direction away from the substrate.

In some embodiments, the ratio of the minimum width to the maximum width of the cross-section is less than or equal to 0.8.

In some embodiments, the maximum width of the cross-section is 5µm to 100µm, and the depth of the texture grooves is 2µm to 50µm.

In some embodiments, the shape of the cross-section of the texture groove perpendicular to the extension direction is trapezoidal, the lower base of the trapezoid is away from the substrate, and the upper base of the trapezoid is close to the substrate.

In some embodiments, the length ratio of the upper base to the lower base is less than or equal to 0.8.

In some embodiments, the length of the lower base is 5µm to 100µm, and the height of the trapezoid is 2µm to 50µm.

In some embodiments, the number of texture grooves in the texture units is greater than or equal to 3.

In some embodiments, the material of the decorative layer includes at least one of metal or glass.

In some embodiments, the decorative plate further includes a finishing layer, wherein the finishing layer includes at least one of a color-developing layer, a frosted layer, or a shimmer layer, and the finishing layer is disposed on the surface of at least one of the decorative layer or the substrate.

In some embodiments, the color-developing layer includes at least one of a plating layer and an ink layer.

The second aspect of the present disclosure provides a method for manufacturing a decorative plate, which includes:

Forming a photoresist layer on the surface of a substrate; exposing the area to be etched after exposure and development; and placing the substrate in an etching solution to etch and form a decorative layer, thereby obtaining the decorative plate; the decorative plate includes a substrate and a decorative layer disposed on the surface of the substrate, wherein the surface of the decorative layer away from the substrate has at least one unit block, the unit block is provided with multiple texture units in a first direction, the texture units have multiple texture grooves, and the extension directions of the multiple texture grooves are the same; the extension direction of the texture grooves forms an extension angle with the first direction, and in the first direction, the extension angles of the texture grooves in adjacent texture units gradually change.

In some embodiments, the material of the substrate includes aluminum alloy, the etching solution includes phosphoric acid, nitric acid, acetic acid, malic acid, surfactant, and water, and the etching time is 2min to 10min.

In some embodiments, the material of the substrate includes glass, the etching solution includes hydrofluoric acid, water, and additives, and the etching time is 2min to 10min.

The method for preparing the decorative plate according to the present disclosure is simple and easy to operate, with mature technology and convenient for industrial production.

The third aspect of the present disclosure provides an electronic device, which includes a display component and a housing cooperating with the display component, wherein the housing includes the decorative plate as described in the first aspect.

### BRIEF DESCRIPTION OF THE DRAWINGS

Figure 1 is a front view of a decorative plate according to an embodiment of the present disclosure;
Figure 2 is a top view of a decorative layer according to an embodiment of the present disclosure;
Figure 3 is a top view of a decorative layer according to an embodiment of the present disclosure;
Figure 4 is a structural diagram of a unit block according to an embodiment of the present disclosure;
Figure 5 is a structural diagram of a texture unit according to an embodiment of the present disclosure;
Figure 6 is a structural diagram of a unit block according to an embodiment of the present disclosure;
Figure 7 is a partial structural diagram of a unit block according to an embodiment of the present disclosure;
Figure 8 is a structural diagram of a unit block according to an embodiment of the present disclosure;
Figure 9 is a structural diagram of a unit block according to an embodiment of the present disclosure;
Figure 10 is a structural diagram of a unit block according to an embodiment of the present disclosure;
Figure 11 is a cross-sectional diagram of a decorative plate according to an embodiment of the present disclosure;
Figure 12 is a cross-sectional diagram of a decorative layer according to an embodiment of the present disclosure;
Figure 13 is a structural diagram of a texture unit according to an embodiment of the present disclosure;
Figure 14 is a structural diagram of an electronic device according to an embodiment of the present disclosure;
Figure 15 is a front view of a decorative plate according to an embodiment of the present disclosure.

### DETAILED DESCRIPTION

The following will provide a clear and complete description of the technical solutions in the embodiments of the present disclosure in conjunction with the accompanying drawings in the embodiments of the present disclosure. It is evident that the described embodiments are merely a part of the embodiments of the present disclosure, and not all embodiments. Based on the embodiments in the present disclosure, all other embodiments obtained by ordinary technicians in the field without creative labor belong to the protection scope of the present disclosure.

In the description of the present disclosure, it should be understood that terms such as "length", "width", "thickness", "horizontal", etc., indicate orientation or positional relationships based on the orientations or positional relationships shown in the drawings, merely for the convenience of describing the present disclosure and simplifying the description, and do not indicate or imply that the device or element must have a specific orientation or be constructed and operated in a specific orientation, so they cannot be understood as limitations to the present disclosure.

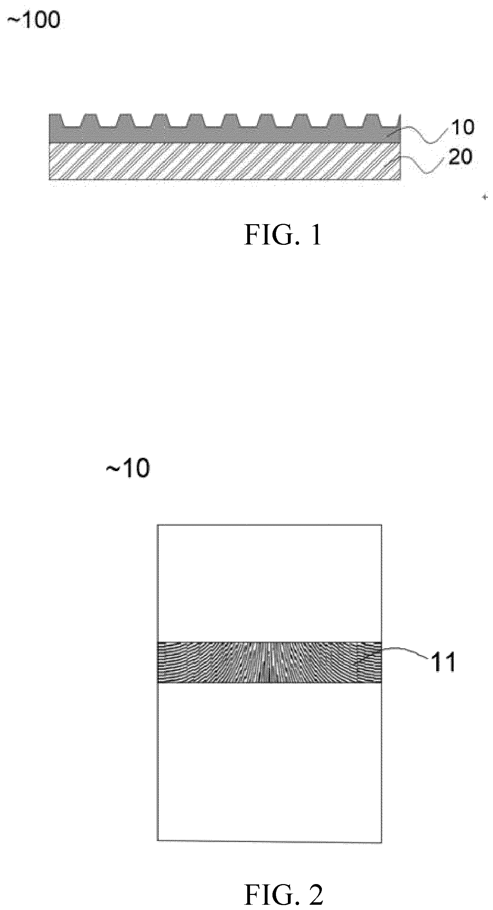

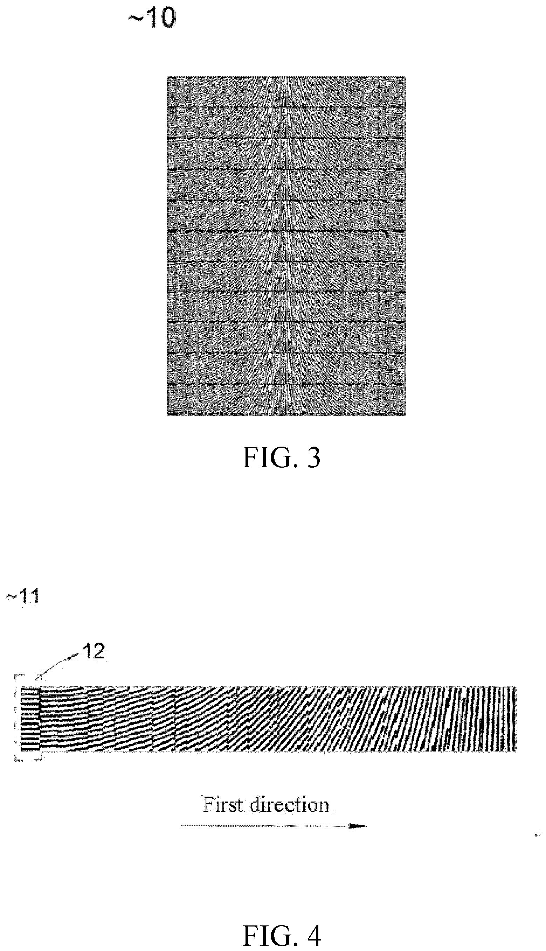

As shown in FIG. 1, FIG. 1 is a front view of a decorative plate according to an embodiment of the present disclosure. The decorative plate 100 includes a substrate 20 and a decorative layer 10 disposed on the surface of the substrate 20, wherein the material of the substrate includes at least one of plastic, metal, ceramic, and glass, and the material of the decorative layer includes at least one of metal or glass. As shown in FIG. 2, FIG. 2 is a top view of the decorative layer according to an embodiment of the present disclosure. The surface of the decorative layer has unit blocks 11. In some embodiments of the present disclosure, the surface of the decorative layer has multiple unit blocks 11. As shown in FIG. 3, FIG. 3 is a top view of the decorative layer according to an embodiment of the present disclosure. The multiple unit blocks 11 on the surface of the decorative layer combine to form a decorative pattern. In embodiments of the present disclosure, the surface of the decorative layer may have multiple unit blocks of different shapes, such as circular unit blocks and S-shaped unit blocks, and unit blocks of different shapes can be arbitrarily combined to form new decorative patterns.

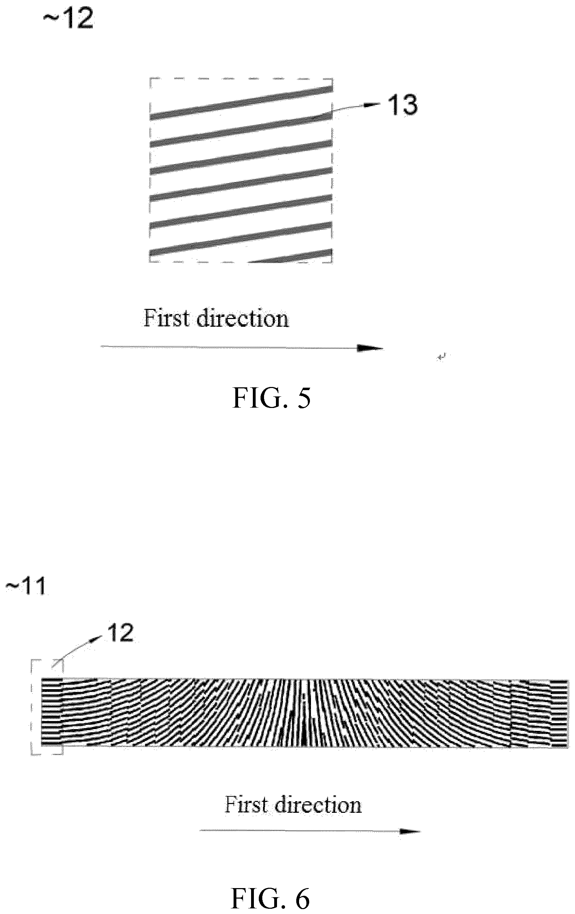

In an embodiment of the present disclosure, the unit block is designed with multiple continuously arranged texture units along the first direction, and each texture unit includes multiple texture grooves with the same extension direction. The extension direction of these texture grooves can be straight or curved. As shown in FIG. 4, FIG. 4 is a structural diagram of a unit block according to an embodiment of the present disclosure. The unit block 11 features multiple consecutively arranged texture units 12 along the first direction, with texture grooves (indicated by the black lines in FIG. 4) within each texture unit. As shown in FIG. 5, FIG. 5 is a structural diagram of a texture unit according to an embodiment of the present disclosure. The extension directions of texture grooves 13 within the same texture unit are parallel to each other, meaning all texture grooves within a single texture unit share the same extension angle. In this present disclosure, the extension angle of texture grooves refers to the angle between the extension direction of the texture grooves and the first direction. Since the extension directions of texture grooves are parallel within the same texture unit, the extension angles of all texture grooves in a texture unit are equal, allowing us to use the extension angle to represent the specific texture unit. For example, in a texture unit with an extension angle of 0°, all texture grooves have an extension angle of 0°.

In an embodiment of the present disclosure, adjacent texture units have different extension directions for their texture grooves, and along the first direction, the extension angles of texture grooves in different texture units gradually change. These changes can be gradual increases, gradual decreases, or a combination of both, such as first increasing and then decreasing, or first decreasing and then increasing. It should be noted that "gradual change" in this present disclosure can refer to changes based on a preset variation amount or a gradient change, without limitation. Since adjacent texture units have different extension angles for their texture grooves, the reflection angle of light changes along the first direction, thereby affecting the intensity of light entering the human eye. The gradual change in extension angles of texture grooves produces a natural variation in light intensity, leading to a visually gradual transition between light and dark. As the viewing angle changes, the light and dark regions shift, creating a dynamic light and shadow effect. In FIG. 4, along the first direction, the extension angles of texture grooves in different texture units gradually change from 0° to 90°. For the unit block in FIG. 4, as the viewing angle changes, the light and shadow flow along the first direction from the texture unit with an extension angle of 0° to the one with an extension angle of 90°, or with an extension angle of 90° to the one with an extension angle of 0°.In some embodiments of the present disclosure, the variation amount of extension angles between adjacent texture units ranges from 0.5° to 10°, which can specifically be but is not limited to 0.5°, 0.8°, 1°, 3°, 5°, 6°, 7°, 8°, 9°, or 10°. Controlling the variation amount of extension angles between adjacent texture units ensures a smooth flow of light and shadow effects, making the overall gradation of the decorative layer natural and enhancing the user experience. In some embodiments of the present disclosure, the size of texture units along the first direction ranges from 0.1mm to 0.5mm, which can specifically be but is not limited to 0.1mm, 0.2mm, 0.3mm, 0.4mm, or 0.5mm.

As shown in FIG. 6, FIG. 6 is a structural diagram of a unit block according to an embodiment of the present disclosure. In FIG. 6, along the first direction, the extension angles of texture grooves in different texture units gradually change from 0° to 90° and then from 90° to 180°. For the unit block in FIG. 6, as the viewing angle changes, light and shadow flow from both sides of the unit block to the middle texture unit with an extension angle of 90°, or from the middle to both sides, meaning light and shadow flow between 0° and 90° and/or between 90° and 180°.

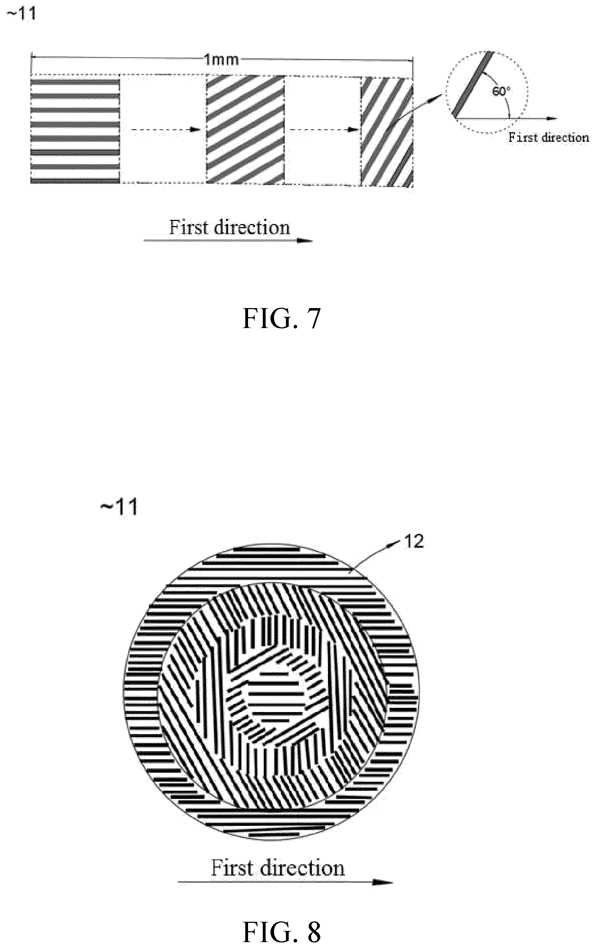

In some embodiments of the present disclosure, the first direction is linear, and the shape of the unit block is rectangular. Along the first direction, the variation amount of extension angles of texture grooves in multiple texture units per 1mm ranges from 15° to 80°. It should be noted that the linear direction can be horizontal, vertical, or any other planar direction with an angle to the horizontal and vertical directions in the present disclosure. For example, in FIG. 7, the linear direction is from left to right horizontally. When the shape of the unit block is rectangular, the variation amount of extension angles of texture grooves in multiple texture units per 1mm can specifically be but is not limited to 15°, 20°, 30°, 40°, 50°, 60°, or 80°. In some embodiments, when the shape of the unit block is rectangular, the variation in the extension angle of the texture grooves in multiple texture units within a distance of per 1mm in the first direction is between 25° and 40°. Controlling the variation in the extension angle of the texture grooves per unit length in the rectangular unit block to be between 15° and 80° can make the light and shadow effects more pronounced, thereby enhancing the product's recognizability. As shown in FIG. 7, FIG. 7 is a partial structural diagram of a unit block according to an embodiment of the present disclosure. In FIG. 7, within a length of 1mm, the extension angle of the texture groove in the leftmost texture unit is 0°, while the extension angle in the rightmost texture unit is 60°. This means that the variation in the extension angle of the texture grooves in multiple texture units over a distance of 1mm is 60°.

In some embodiments of the present disclosure, the variation in the extension angle of the texture grooves in the texture units on both sides of the rectangular unit block in the first direction is 90°. The structural schematic is shown in FIG. 4. In FIG. 4, the extension angle A₁ of the leftmost texture unit in the first direction is 0°, while the extension angle A₂ of the rightmost texture unit is 90°. Therefore, the difference in the extension angles of the texture grooves in the texture units on both sides in the first direction is 90°. When the difference between A₁ and A₂ is 90°, the extension directions of the texture grooves on both sides are perpendicular to each other, resulting in one side having the strongest light and shadow effect and the other side having the weakest. Thus, the light and shadow variation effect is more pronounced.

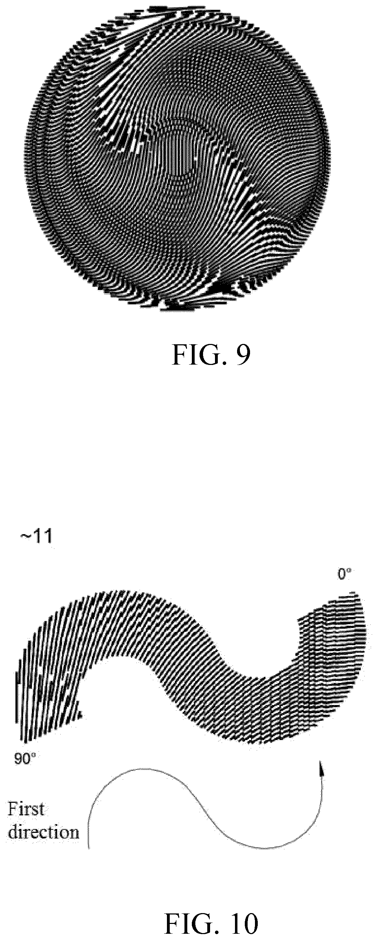

In some embodiments of the present disclosure, the first direction is a straight line direction, and the shape of the unit block is circular. The first direction is the radial direction of the circle. As shown in FIG. 8, FIG. 8 is a structural diagram of a unit block according to an embodiment of the present disclosure. The texture unit at the center of the unit block 11 is circular, and the texture units 12 extending from the center outwards are ring-shaped. Among the texture units from the center to the periphery of the unit block, the change in the extension angle of the texture grooves is 180°. Taking the horizontal direction as the first direction, relative to the first direction, the extension angle of the texture grooves at the center of the circle is 0°. As they extend outwards from the center, the extension angle of the texture grooves gradually increases from 0° to 90°, and then from 90° to 180°. For the unit block with the structure shown in FIG.8, the lighting and shadow change from the center of the circle outwards as the viewing angle changes. As shown inFIG.9, FIG.9 is a structural diagram of a unit block according to an embodiment of the present disclosure. The unit block 11 is circular, and among the texture units from the center to the periphery of the unit block, the change in the extension angle of the texture grooves is 90°. For the unit block with the structure shown in FIG. 9, the lighting and shadow flow between the center and the periphery of the unit block as the viewing angle changes. In some embodiments of the present disclosure, when the shape of the unit block is circular, the change in the extension angle of the texture grooves within every 1mm along the first direction (radial direction of the circle) ranges from 10° to 40° in multiple texture units. When the shape of the unit block is circular, the change in the extension angle of the texture grooves within every 1mm along the first direction can be, but is not limited to 10°, 15°, 20°, 25°, 30°, 35°, or 40° in multiple texture units. In some embodiments, when the shape of the unit block is circular, the change in the extension angle of the texture grooves within every 1mm along the first direction ranges from 20° to 30° in multiple texture units. Controlling the change of the extension angle of the texture groove per unit length in the circular unit block can make the effect of light and shadow change more significant and improve the recognition of the product.

In some embodiments of the present disclosure, the change in the extension angle of the texture grooves in the texture units on both sides along the first direction in the circular unit block is 90°, as shown in the structural diagram of FIG. 9. In FIG. 9, the first direction is the radial direction of the circle. The extension angle of the texture unit at the center of the circle is A₃, and the extension angle of the texture unit in the outermost ring of the unit block is A₄. The difference between A₃ and A₄ is 90°. When the difference between A₁ and A₂ is 90°, the extension directions of the texture grooves on both sides are perpendicular to each other, with the strongest lighting and shadow on one side and the weakest on the other, making the effect of lighting and shadow changes more significant.

In some embodiments of the present disclosure, the first direction is a curved direction, which can be any non-straight direction of any shape. As shown in FIG. 10, FIG. 10 is a structural diagram of a unit block according to an embodiment of the present disclosure. In FIG. 10, the first direction is in an S-shaped curve, and the unit block also presents an S-shape. Along the first direction, the angle between the extension direction of the texture grooves in different texture units and the first direction gradually changes from 0° to 90°. For the unit block with the structure shown in FIG. 10, as the viewing angle changes, the lighting and shadow flow from one end of the S-shape to the other, i.e., between the extension angles of 0° and 90° of the texture units. In some embodiments of the present disclosure, when the shape of the unit block is S-shaped, the change in the extension angle of the texture grooves within every 1mm along the first direction (curve direction of the S-shape) ranges from 6° to 35°in multiple texture units. The 1mm distance refers to the length of the arc segment being 1mm. When the shape of the unit block is S-shaped, in the first direction, within a distance of 1mm, the change of the extension angle of the texture groove in multiple texture units can specifically be, but is not limited to 6 ° , 10° , 15° , 20° , 25° , 30° , or 35° . In some embodiments, when the shape of the unit block is S-shaped, in the first direction, within a distance of 1mm, the change of the extension angle of the texture groove in multiple texture units is 10° ~25° .

In some embodiments of the present disclosure, the change in the extension angle of the texture grooves in the texture units on both sides along the first direction in the S-shaped unit block is 90°, as shown in the structural diagram of FIG. 10. In FIG. 10, the first direction is the curve direction of the S-shape. The extension angle of the texture unit at the starting point of the S-shape is A₅, and the extension angle of the texture unit at the end of the S-shape is A₆. Therefore, the difference between A₅ and A6 is 90°. When the difference between A₅ and A₆ is 90°, the extension directions of the texture grooves on both sides are perpendicular to each other, with the strongest lighting and shadow on one side and the weakest on the other, leading to a more significant effect of lighting and shadow changes.

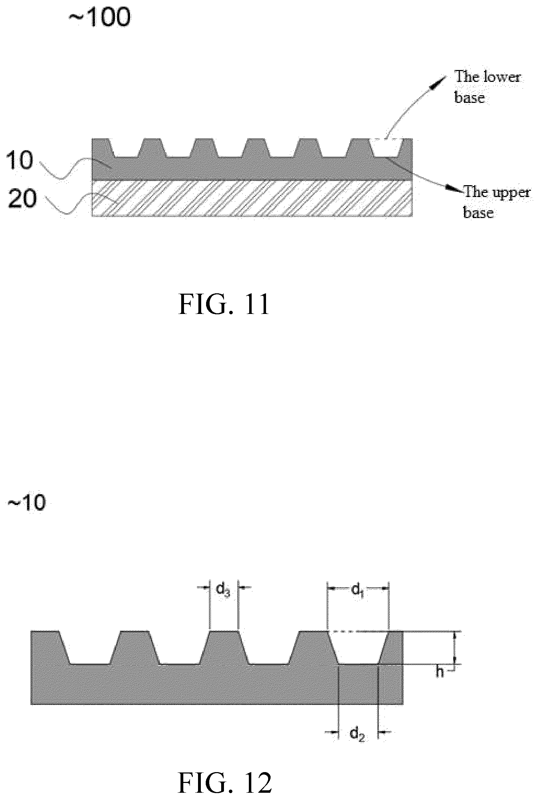

In some embodiments of the present disclosure, the texture grooves have an upper-wide-lower-narrow concave structure, meaning that the width of the cross-section of the texture grooves perpendicular to their extension direction gradually increases in the direction away from the substrate. In some embodiments, the cross-sectional shape of the texture grooves perpendicular to their extension direction is trapezoidal. As shown in FIG. 11, FIG. 11 is a cross-sectional diagram of a decorative plate according to an embodiment of the present disclosure. In FIG. 11, the cross-sectional shape of the texture grooves perpendicular to their extension direction is trapezoidal. The lower base of the trapezoid is far from the substrate 20, while the upper base is close to the substrate 20. Here, the lower base refers to the longer base of the trapezoid, and the upper base refers to the shorter base. This trapezoidal structure of the texture grooves helps increase the intensity of light reflection, makes the changes in brightness and darkness at different positions in the unit block more obvious and clear, thereby enhancing the depth perception of the unit block.

In some embodiments of the present disclosure, the ratio of the minimum width to the maximum width of the cross-section of the texture grooves perpendicular to their extension direction is less than or equal to 0.8. A larger difference in the upper and lower widths of the cross-section of the texture grooves helps increase the intensity of reflected light, achieves a more significant change in lighting and shadow. In some examples, the cross-sectional shape of the texture grooves is trapezoidal, and the ratio of the length of the upper base to the length of the lower base of the trapezoid is less than or equal to 0.8. Specifically, but not limited to, this ratio can be 0.8, 0.75, 0.7, 0.65, 0.6, 0.5, 0.45, or 0.3. In some embodiments of the present disclosure, the maximum width of the cross-section of the texture grooves perpendicular to their extension direction ranges from 5 µm to 100 µm, and the depth of the texture grooves ranges from 2 µm to 50 µm, where the depth refers to the dimension along the direction from the decorative layer to the substrate. As shown in FIG. 12, FIG.12 is a cross-sectional diagram of a decorative layer according to an embodiment of the present disclosure. In the decorative layer, the cross-sectional shape of the texture grooves is trapezoidal. The depth h of the texture grooves is the height of the trapezoid, the width d₁ at the top of the texture grooves is the length of the lower base of the trapezoid, the width d₂ at the bottom of the texture grooves is the length of the upper base of the trapezoid, and the distance d₃ between adjacent texture grooves is the spacing of the lower bases of the trapezoids. In some embodiments of the present disclosure, the width d₁ at the top of the texture grooves ranges from 5 µm to 100 µm, specifically but not limited to 5 µm, 10 µm, 20 µm, 30 µm, 50 µm, 80 µm, or 100 µm. In some embodiments of the present disclosure, the depth h of the texture grooves ranges from 2 µm to 50 µm, specifically but not limited to 2 µm, 5 µm, 7 µm, 10 µm, 20 µm, 30 µm, or 50 µm. In some embodiments of the present disclosure, the distance d₃ between adjacent texture grooves ranges from 5 µm to 120 µm, specifically but not limited to 5 µm, 10 µm, 20 µm, 30 µm, 50 µm, 80 µm, 100 µm, or 120 µm.

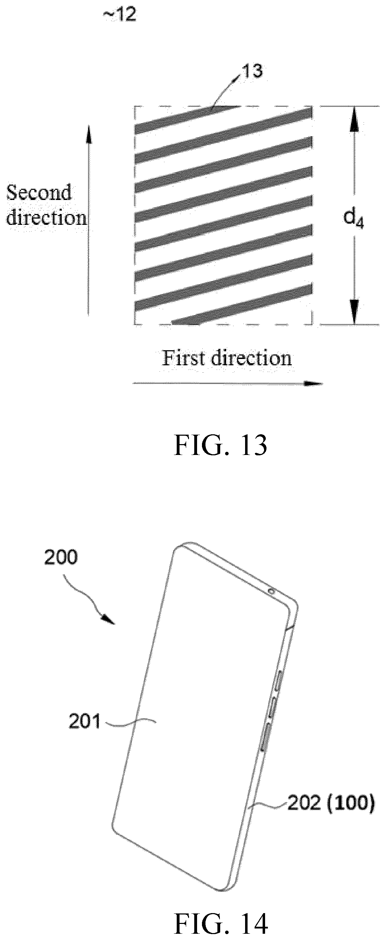

In some embodiments of the present disclosure, the number of texture grooves in a single texture unit is greater than or equal to 3. Controlling the number of texture grooves to be greater than or equal to 3 helps improve the smoothness of light and shadow flow, making the changes in lighting and shadow more delicate. As shown in FIG. 13, FIG. 13 is a structural diagram of a texture unit according to an embodiment of the present disclosure. In FIG. 13, the number of texture grooves in the texture unit is 8.

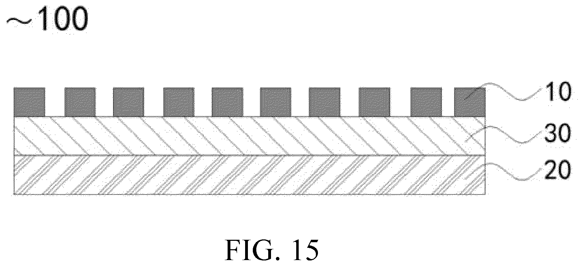

In some embodiments of the present disclosure, the decorative plate further includes a finishing layer 30, which includes at least one of a color-developing layer, a matte layer, and a shimmer layer. In the present disclosure, the color-developing layer has a specific color, enabling the decorative plate to exhibit diverse color gradient effects. In some embodiments, the color-developing layer includes one or more of a coating layer and an ink layer. In some examples, the material of the decorative layer in the decorative plate includes aluminum alloy, and the surface of the decorative layer is provided with a coating layer formed by anodizing aluminum oxide. This coating layer not only has a specific color but also improves the wear resistance of the decorative plate, thereby extending the product's service life. The matte layer has a certain anti-slip function and a softer visual effect, enriching the appearance of the product. The shimmer layer refers to a finishing layer capable of presenting a shimmering effect. In some embodiments, the shimmer layer includes a coating doped with shimmer particles, which can give the decorative plate a certain iridescent effect. In some embodiments, the finishing layer 30 is disposed on the surface of the decorative layer 10. In some embodiments, the finishing layer 30 is disposed on the surface of the substrate 20. In some embodiments, the finishing layer 30 is disposed on both the surface of the substrate 20 and the decorative layer 10 (see FIG. 15).

The present disclosure also provides a method for manufacturing the decorative plate. In some embodiments of the present disclosure, the manufacturing method for the decorative plate includes: forming a photoresist layer on the surface of a substrate, exposing and developing the photoresist layer to expose the regions to be etched, placing the substrate in an etching solution to etch and form the decorative layer, thereby obtaining the decorative plate. In some embodiments of the present disclosure, before forming the photoresist layer, the substrate is cleaned to remove oil and impurities from its surface. Plasma cleaning can be used for cleaning, which can reduce the surface energy of the substrate and facilitate uniform adhesion of the photoresist layer on the substrate surface. Plasma cleaning can be either plasma physical cleaning or plasma chemical cleaning.

In some embodiments, the material of the substrate includes aluminum alloy, and the manufacturing method for the decorative plate includes: preparing a photoresist layer on the surface of the aluminum alloy, with a thickness of 2µm to 12µm. The photoresist layer can be prepared by any of spraying, coating, or immersion. Laser direct imaging (LDI) technology is used to expose the texture pattern onto the photoresist. This exposure equipment can directly expose the target texture through a light source at the specified position on the product, achieving exposure at the desired locations and non-exposure at undesired locations. The substrate is then placed in a developer solution for development, which removes the exposed photoresist, exposing the aluminum alloy, while the unexposed photoresist remains on the surface of the aluminum alloy, providing protection. The aluminum alloy is then placed in an etching solution for etching. The etching solution includes phosphoric acid, nitric acid, acetic acid, malic acid, surfactant, and water. The etching time is 2min to 10min. During the etching process, the regions of the aluminum alloy surface without photoresist protection come into contact with the etching solution and are etched to be thinned, forming pits on the aluminum alloy surface. The regions with photoresist protection are not etched, thereby forming the decorative layer. The photoresist on the surface of the decorative plate is removed using a stripping agent to obtain the decorative plate. In some embodiments of the present disclosure, after removing the photoresist, the aluminum alloy can be anodized to form a coating layer on the surface of the decorative layer. The anodizing electrolyte includes sulfuric acid, with an anodizing temperature of 15°C to 30°C, an anodizing current density of 0.9A/dm² to 1.6A/dm², and an anodizing time of 15min to 30min. In some embodiments of the present disclosure, after removing the photoresist, a graphic layer (ink layer) can be formed on the surface of the decorative layer by thermal transfer printing, which can further enrich the appearance of the decorative plate.

In some embodiments of the present disclosure, the photoresist is a low-molecular-weight photoresist with a molecular weight of 3000-4000. In some embodiments, the photoresist system includes one or more of olefinic compounds, azidoquinones, silicon-containing acrylics, phenolic resins, and polyvinyl laurate. The above-mentioned photoresist systems can form lines with clear edges after exposure and development, resulting in high-precision patterns. In some embodiments, the thickness of the photoresist is 2µm to 6µm. In some embodiments of the present disclosure, the developer solution includes one or more of potassium hydroxide, sodium hydroxide, sodium carbonate, or potassium carbonate, with a conductivity of 10ms/cm to 100ms/cm and a mass percentage of 0.01% to 20%.

In some embodiments, the material of the substrate includes glass, and the manufacturing method for the decorative plate includes: preparing a photoresist layer on the surface of the glass; exposing the texture pattern onto the photoresist using laser direct imaging technology; placing the glass with photoresist in a developer solution for development, then placing it in an etching solution for etching to form a decorative layer on the glass surface. The etching solution includes hydrofluoric acid, water, and additives, with an etching time of 2min to 10min. The photoresist is removed using a stripping agent to obtain the decorative plate.

The method for manufacturing the decorative plate according to the present disclosure is technically mature and straightforward. Compared to the traditional yellow light process with a sampling time of 3-4 days, this method only requires 3-4 hours for sampling, significantly improving production efficiency. Laser direct imaging technology enables direct exposure of the texture pattern onto the photoresist surface, resulting in high-precision exposure patterns and diverse patterns. Products prepared using this method exhibit high stability, contributing to an increased yield rate and suitability for mass production.

The present disclosure also provides an electronic device that includes the decorative plate of the present disclosure. As shown in FIG. 14, FIG. 14 is a structural diagram of an electronic device according to an embodiment of the present disclosure. The electronic device 200 includes a display assembly 201 and a housing 202 cooperating with the display assembly 201, wherein the housing 202 includes the decorative plate 100 of the present disclosure. In embodiments of the present disclosure, the electronic device can specifically be a mobile phone, computer, watch, USB flash drive, electronic cigarette, wearable device, digital camera, etc.

The following provides further explanation of the embodiments of the present disclosure through specific examples.

### Example 1

A method for manufacturing a decorative plate includes:
1) Provide an aluminum alloy substrate with a curved surface structure. Clean the aluminum alloy surface with an SP-101 degreaser, RC-800 rust remover, and water to remove impurities on the surface of the aluminum alloy substrate, revealing a bright aluminum alloy surface. Then bake the aluminum alloy substrate at 90°C for 30 minutes. Place the aluminum alloy substrate in a plasma cleaner for 5 minutes.
2) Place the cleaned aluminum alloy substrate in a spraying device to apply a photoresist layer on the surface of the product. The thickness of the photoresist layer is 7µm, and the photoresist is composed of methyl phenolic resin. Then, bake the substrate in an oven at 90°C for 10 minutes.
3) Create the target texture pattern using software such as AI, Photoshop, CAD, etc. The texture pattern for Example 1 is shown in FIG.9. Import the created texture pattern into the LDI exposure equipment and place the aluminum alloy substrate with the photoresist layer into the LDI exposure equipment for exposure. The exposure current is 20mA, and the speed is 10mm/s.
4) Place the exposed product into a horizontal development and cleaning line. The developer solution contains potassium hydroxide and a defoamer, with a potassium hydroxide mass concentration of 3%. The conductivity of the developer solution is 40ms/cm. Control the development line speed at 4m/min, the temperature at 25°C, and the pressure of the development nozzle at 10 kg. Place the developed product in an oven for curing at 150°C for 30 minutes.
5) Perform etching on the cured product. The etching solution includes the following mass percentages of ingredients: 60% phosphoric acid, 20% nitric acid, 12% acetic acid, 4% malic acid, and 4% surfactant. The etching time is 5 minutes. The etching depth of the aluminum alloy surface uncovered by the photoresist is 10µm, forming a decorative layer. Rinse the etched product thoroughly.
6) Place the etched product in a stripping solution. The stripping solution includes the following mass percentages of ingredients: 25% triethanolamine, 40% ethylene glycol ether, 10% ethylene glycol phenyl ether, 8% benzyl alcohol, 2% surfactant, and 15% N-methyl-2-pyrrolidone. Assist the stripping process with ultrasonic waves or bubbling, controlling the temperature at 60°C. The stripping time is 7 minutes, removing the photoresist from the surface of the aluminum alloy.
7) Clean the aluminum alloy and then perform anodizing. Immerse the aluminum alloy in an anodizing solution (composed of 160g/L sulfuric acid). At 25°C, control the current density at 1.3A/dm² for 20 minutes to form anodic pores. Then, dye the aluminum alloy in a dyeing bath. Finally, seal the pores in a sealing bath containing a 6% nickel acetate sealing agent to form a coating layer, ultimately obtaining a decorative plate with colorful light and shadow variations.

### Example 2

A method for manufacturing a decorative plate includes:
1) Provide an aluminum alloy substrate with a curved surface structure. Clean the aluminum alloy surface with SP-101 degreaser, RC-800 rust remover, and water to remove impurities on the surface of the aluminum alloy substrate, revealing a bright aluminum alloy surface. Then bake the aluminum alloy substrate at 90°C for 30 minutes. Place the aluminum alloy substrate in a plasma cleaner for 5 minutes.
2) Place the cleaned aluminum alloy substrate in a spraying device to apply a photoresist layer on the surface of the product. The thickness of the photoresist layer is 8µm, and the photoresist is composed of methyl phenolic resin. Then, bake the substrate in an oven at 100°C for 8 minutes.
3) Create the target texture pattern using software such as AI, Photoshop, CAD, etc. The texture pattern for Example 2 is shown in FIG. 4. Import the created texture pattern into the LDI exposure equipment and place the aluminum alloy substrate with the photoresist layer into the LDI exposure equipment for exposure. The exposure current is 10mA, and the speed is 10mm/s.
4) Place the exposed product into a horizontal development and cleaning line. The developer solution contains potassium hydroxide and a defoamer, with a potassium hydroxide mass concentration of 8%. The conductivity of the developer solution is 40ms/cm. Control the development line speed at 4m/min, the temperature at 25°C, and the pressure of the development nozzle at 10 kg. Place the developed product in an oven for curing at 150°C for 30 minutes.
5) Perform etching on the cured product. The etching solution includes the following mass percentages of ingredients: 60% phosphoric acid, 20% nitric acid, 12% acetic acid, 4% malic acid, and 4% surfactant. The etching time is 5 minutes. The etching depth of the aluminum alloy surface uncovered by the photoresist is 10µm, forming a decorative layer. Rinse the etched product thoroughly.
6) Place the etched product in a stripping solution. The stripping solution includes the following mass percentages of ingredients: 25% triethanolamine, 40% ethylene glycol ether, 10% ethylene glycol phenyl ether, 8% benzyl alcohol, 2% surfactant, and 15% N-methyl-2-pyrrolidone. Assist the stripping process with ultrasonic waves or bubbling, controlling the temperature at 60°C. The stripping time is 8 minutes, removing the photoresist from the surface of the aluminum alloy.
7) Clean the aluminum alloy and then perform anodizing to form micropores on its surface. Immerse the aluminum alloy in an anodizing solution (composed of 160g/L sulfuric acid). At 25°C, control the current density at 1.3A/dm² for 20 minutes to form micropores. The median pore diameter of the micropores on the treated aluminum alloy surface is 50nm, and the pore depth of the micropores is 5µm. Place the aluminum alloy in a 90°C oven for 30 minutes to dry.
8) Take the dried aluminum alloy and adhere the graphics and text on a thermal sublimation paper to the corresponding position on the aluminum alloy. Place the aluminum alloy with the adhered thermal sublimation paper in a sealing device. By evacuating the device (to a vacuum level of 0.05 pa), the sealing device ensures that the thermal sublimation paper adheres tightly to the surface of the aluminum alloy. Place the sealing device in a preheated oven, set the baking temperature to 80°C, and bake for 360 minutes. After baking, allow the aluminum alloy to cool naturally. Remove the adhered thermal sublimation paper, and place the transferred aluminum alloy piece in a 6% nickel acetate sealing agent solution. Immerse it at 95°C for 20 minutes for sealing. Then, rinse with water and bake in a 90°C oven for 30 minutes to dry. This completes the decorative plate as described in the present disclosure.

### Example 3

A method for manufacturing a decorative plate includes:
1) Provide a glass substrate and clean it to remove surface impurities. Place the glass substrate in a plasma cleaner for 5 minutes.
2) Place the cleaned glass substrate in a spraying device to apply a photoresist layer on the surface of the product. The thickness of the photoresist layer is 7µm, and the photoresist is composed of methyl phenolic resin. Then, bake the substrate in an oven at 100°C for 8 minutes.
3) Create the target texture pattern using software such as AI, Photoshop, CAD, etc. The texture pattern for Example 3 is shown in FIG. 10. Import the created texture pattern into the LDI exposure equipment and place the glass substrate with the photoresist layer into the LDI exposure equipment for exposure. The exposure current is 15mA, and the speed is 20mm/s.
4) Place the exposed product into a horizontal development and cleaning line. The developer solution contains potassium hydroxide and a defoamer, with a potassium hydroxide mass concentration of 3%. The conductivity of the developer solution is 40ms/cm. Control the development line speed at 4m/min, the temperature at 25°C, and the pressure of the development nozzle at 10 kg. Place the developed product in an oven for curing at 150°C for 30 minutes.
5) Perform etching on the cured product. The etching solution includes the following mass percentages of ingredients: 40% HF, 40% water, and 20% dispersant and corrosion inhibitor. The etching time is 4 minutes. The etching depth of the glass surface uncovered by the photoresist is 15µm, forming a decorative layer. Rinse the etched product thoroughly.
6) Place the etched product in a stripping solution, which is a 40% sodium hydroxide aqueous solution. Assist the stripping process with ultrasonic waves or bubbling, controlling the temperature at 80°C. The stripping time is 2 minutes. Strip the photoresist from the surface of the glass and dry it to obtain the decorative plate.

It should be noted that the above-mentioned examples only represent one embodiment of the present disclosure, and the description is relatively specific and detailed. However, this should not be construed as limiting the scope of the patent claims of the present disclosure. It should be pointed out that ordinary technicians in the field can make several deformations and improvements without departing from the design concept of the present disclosure, all of which fall within the protection scope of the present disclosure. Therefore, the scope of protection of the present disclosure should be based on the appended claims.

## Claims

1. A decorative plate (100), comprising a substrate (20) and a decorative layer (10) arranged on the surface of the substrate, the surface of the decorative layer away from the substrate having at least one unit block (11), the at least one unit block being provided with a plurality of continuously arranged texture units (12) in a first direction, each of the plurality of texture units being provided with a plurality of texture grooves (13), and an extension direction of the plurality of texture grooves being the same; an angle between the extension direction of the plurality of the texture grooves and the first direction being an extension angle, and in the first direction, the extension angles of the plurality of texture grooves in the different texture units gradually varying.

2. The decorative plate according to claim 1, wherein the variation in the extension angle of the plurality of texture grooves in adjacent texture units is 0.5° to 10°.

3. The decorative plate according to claim 1, wherein a size of the plurality of texture unit in the first direction is 0.1mm to 0.5mm.

4. The decorative plate according to claim 1, wherein the first direction is a linear direction, the unit block is circular, the first direction is a radial direction of the circle, and the variation in the extension angle of the plurality of texture grooves in the plurality of texture units within every 1mm distance along the first direction is 10° to 40°.

5. The decorative plate according to claim 1, wherein the first direction is a linear direction, the unit block is rectangular, and the variation in the extension angle of the texture groove in the plurality of texture units within every 1mm distance along the first direction is 15° to 80°.

6. The decorative plate according to claim 1, wherein the first direction is a curved direction, the unit block is S-shaped, and the variation in the extension angle of the texture grooves in the plurality of texture units within every 1mm distance along the first direction is 6° to 35°.

7. The decorative plate according to claim 1, wherein a distance between the adjacent texture grooves in the plurality of texture unit is 5µm to 120µm .

8. The decorative plate according to claim 1, wherein a width of a cross-section of the texture groove perpendicular to the extension direction gradually increases in a direction away from the substrate.

9. The decorative plate according to claim 8, wherein a ratio of the minimum width of the cross-section of the texture groove to the maximum width of the cross-section of the texture groove being less than or equal to 0.8.

10. The decorative plate according to claim 8 or 9, wherein the maximum width of the cross-section is 5µm to 100µm, and a depth of the texture groove is 2µm to 50µm.

11. The decorative plate according to claim 1, wherein the cross-section of the texture groove perpendicular to the extension direction is trapezoidal; a lower base of the trapezoid is away from the substrate, and an upper base of the trapezoid is close to the substrate.

12. The decorative plate according to claim 11, wherein a length ratio of the upper base to the lower base is less than or equal to 0.8.

13. The decorative plate according to claim 11, wherein a length of the lower base is 5µm to 100µm, and the height of the trapezoid is 2µm to 50µm.

14. The decorative plate according to claim 1, wherein the number of texture grooves in the texture unit is greater than or equal to 3.

15. The decorative plate according to any one of claims 1-14, wherein a material of the decorative layer comprises at least one of metal or glass.

16. The decorative plate according to any one of claims 1-15, wherein the decorative plate further comprises a finishing layer, wherein the finishing layer comprises at least one of a color-developing layer, a frosted layer, or a shimmer layer, and the finishing layer is disposed on the surface of at least one of the decorative layer or the substrate.

17. A method for manufacturing a decorative plate, comprising:
forming a photoresist layer on a surface of a substrate;
exposing and developing to expose an area to be etched; and
placing the substrate in an etching solution to etch and form a decorative layer, thereby obtaining the decorative plate;
the decorative plate comprising a substrate and a decorative layer disposed on the surface of the substrate, wherein the surface of the decorative layer away from the substrate having at least one unit block, the unit block is provided with a plurality of texture units in a first direction, the texture units having a plurality of texture grooves,
and an extension direction of the the plurality of texture grooves being the same; an angle between the extension direction of the texture groove and the first direction being an extension angle, and in the first direction, the extension angles of the plurality of texture grooves in adjacent texture units gradually change.

18. The method for manufacturing a decorative plate according to claim 17, wherein a material of the substrate comprises an aluminum alloy, the etching solution comprises phosphoric acid, nitric acid, acetic acid, malic acid, surfactant, and water, and an etching time is 2min to 10min.

19. The method for manufacturing a decorative plate according to claim 17, wherein a material of the substrate comprises glass, the etching solution comprises hydrofluoric acid, water, and additives, and an etching time is 2min to 10min.

20. An electronic device (200), wherein the electronic device comprises a display component (201) and a housing (202) cooperating with the display component, wherein the housing comprises the decorative plate (100) according to any one of claims 1-13.
